# EUROPÄISCHE PATENTSCHRIFT

(11) **EP 2 545 196 B1**
(45) Veröffentlichungstag und Bekanntmachung des Hinweises auf die Patenterteilung: **26.06.2019**
(21) Anmeldenummer: 11723860.0
(22) Anmeldetag: 03.03.2011
(51) Int. Cl.: C23C 16/04, C23C 16/511, C23C 16/52, H01J 37/32, G01J 3/443

(54) **VERFAHREN ZUR PLASMABEHANDLUNG VON WERKSTÜCKEN**
METHOD FOR PLASMA-TREATING WORKPIECES
PROCÉDÉ DE TRAITEMENT AU PLASMA DE PIÈCES

(30) Priorität: 12.03.2010 DE 102010012501
(43) Veröffentlichungstag der Anmeldung: 16.01.2013
(73) Patentinhaber: KHS Corpoplast GmbH, 22145 Hamburg (DE)
(72) Erfinder: SIEBELS, Sönke, 22303 Hamburg (DE); KYTZIA, Sebastian, 22301 Hamburg (DE)
(74) Vertreter: Hausfeld, Norbert
(86) Internationale Anmeldenummer: PCT/DE2011/000234
(87) Internationale Veröffentlichungsnummer: WO 2011/110162

(56) Entgegenhaltungen:
- EP-A1- 1 500 600
- EP-A1- 1 630 848
- EP-B1- 1 948 846
- DE-A1-102006 053 366
- DE-A1-102008 016 923
- JP-A- 2005 083 835
- KOUJI YAMAZAKI ET AL: "GRADIENT FIELD PLASMA CVD", NEC RESEARCH AND DEVELOPMENT, NIPPON ELECTRIC LTD. TOKYO, JP, Nr. 85, 1. April 1987 (1987-04-01), Seiten 34-39, XP000111940, ISSN: 0547-051X

## Beschreibung

Die Erfindung betrifft ein Verfahren zur Plasmabehandlung von Werkstücken, bei dem das Werkstück in eine Plasmakammer eingesetzt wird und bei dem anschließend bei Einwirkung eines Unterdruckes nach der Zündung eines Plasmas eine Beschichtung auf dem Werkstück abgeschieden wird sowie bei dem der Verfahrensablauf mindestens zeitweilig optisch überwacht wird.

Weiterhin beschrieben wird eine Vorrichtung zur Plasmabehandlung von Werkstücken, die mindestens eine evakuierbare Plasmakammer zur Aufnahme der Werkstücke aufweist und bei der die Plasmakammer im Bereich einer Behandlungsstation angeordnet ist, sowie bei der die Plasmakammer von einem Kammerboden, einem Kammerdeckel sowie einer seitlichen Kammerwandung begrenzt ist und bei der die Plasmakammer mit einer Einrichtung zur optischen Überwachung eines Verfahrensablaufes gekoppelt ist.

Derartige Verfahren und Vorrichtungen werden beispielsweise eingesetzt, um Kunststoffe mit Oberflächenbeschichtungen zu versehen. Insbesondere sind auch bereits derartige Vorrichtungen bekannt, um innere oder äußere Oberflächen von Behältern zu beschichten, die zur Verpackung von Flüssigkeiten vorgesehen sind. Darüber hinaus sind Einrichtungen zur Plasmasterilisation bekannt.

In der PCT-WO 95/22413 wird eine Plasmakammer zur Innenbeschichtung von Flaschen aus PET beschrieben. Die zu beschichtenden Flaschen werden durch einen beweglichen Boden in eine Plasmakammer hineingehoben und im Bereich einer Flaschenmündung mit einem Adapter in Verbindung gebracht. Durch den Adapter hindurch kann eine Evakuierung des Flascheninnenraumes erfolgen. Darüber hinaus wird durch den Adapter hindurch eine hohle Gaslanze in den Innenraum der Flaschen eingeführt, um Prozeßgas zuzuführen. Eine Zündung des Plasmas erfolgt unter Verwendung einer Mikrowelle.

Aus dieser Veröffentlichung ist es auch bereits bekannt, eine Mehrzahl von Plasmakammern auf einem rotierenden Rad anzuordnen. Hierdurch wird eine hohe Produktionsrate von Flaschen je Zeiteinheit unterstützt.

In der EP-OS 10 10 773 wird eine Zuführeinrichtung erläutert, um einen Flascheninnenraum zu evakuieren und mit Prozeßgas zu versorgen. In der PCT-WO 01/31680 wird eine Plasmakammer beschrieben, in die die Flaschen von einem beweglichen Deckel eingeführt werden, der zuvor mit einem Mündungsbereich der Flaschen verbunden wurde.

Die PCT-WO 00/58631 zeigt ebenfalls bereits die Anordnung von Plasmastationen auf einem rotierenden Rad und beschreibt für eine derartige Anordnung eine gruppenweise Zuordnung von Unterdruckpumpen und Plasmastationen, um eine günstige Evakuierung der Kammern sowie der Innenräume der Flaschen zu unterstützen. Darüber hinaus wird die Beschichtung von mehreren Behältern in einer gemeinsamen Plasmastation bzw. einer gemeinsamen Kavität erwähnt.

Eine weitere Anordnung zur Durchführung einer Innenbeschichtung von Flaschen wird in der PCT-WO 99/17334 beschrieben. Es wird hier insbesondere eine Anordnung eines Mikrowellengenerators oberhalb der Plasmakammer sowie eine Vakuum- und Betriebsmittelzuleitung durch einen Boden der Plasmakammer hindurch beschrieben.

In der DE 10 2004 020 185 A1 wird bereits eine Gaslanze beschrieben, die in den Innenraum eines zu beschichtenden Vorformlings einfahrbar ist und zur Zuleitung von Prozeßgasen dient. Die Gaslanze ist in der Längsrichtung des Behälters positionierbar.

Bei der überwiegenden Anzahl der bekannten Vorrichtungen werden zur Verbesserung von Barriereeigenschaften des thermoplastischen Kunststoffmaterials durch das Plasma erzeugte Behälterschichten aus Siliziumoxiden mit der allgemeinen chemischen Formel SiOₓ verwendet. Derartige Barriereschichten verhindern ein Eindringen von Sauerstoff in die verpackten Flüssigkeiten sowie ein Austreten von Kohlendioxid bei CO₂-haltigen Flüssigkeiten.

Aufgrund der im Plasma enthaltenen chemischen Elemente weist das Plasma charakteristische Spektrallinien auf. In der US 6,117,243 wird deshalb bereits eine optische Überwachung für die Durchführung einer Plasmabeschichtung beschrieben. Es erfolgt hierbei eine Auswertung der Strahlungsemission im Bereich einer Wellenlänge von 425 Nanometer.

In der EP 1 948 846 wird ein weiteres Verfahren zur Überwachung einer Plasmabeschichtung erläutert. Hier erfolgt eine Auswertung in einem Spektralbereich von 800 Nanometer bis 950 Nanometer. Es erfolgt eine Auswertung einer Differenz zwischen Signalen einer ersten Bandbreite als Referenz und Signalen einer zweiten Bandbreite.

Die EP 1 500 600 beschreibt ein ähnliches Verfahren.

Die EP 1 630 848 schließlich beschreibt noch ein weiteres Verfahren, bei dem zur Prozeßüberwachung Pulse gezählt werden und die Anzahl der gezählten Pulse in Bezug zu einer Anzahl Referenzpulse gesetzt wird.

Die bislang bekannt gewordenen Verfahren und Vorrichtungen sind noch nicht ausreichend dafür geeignet, sowohl eine zuverlässige als auch gegenüber veränderlichen Randbedingungen robuste Prozeßüberwachung bereitzustellen.

Aufgabe der vorliegenden Erfindung ist es daher, ein Verfahren der einleitend genannten Art derart zu verbessern, daß eine zuverlässige Prozeßüberwachung unterstützt wird.

Diese Aufgabe wird erfindungsgemäß dadurch gelöst, daß bei der optischen Überwachung Wellenlängen der Emissionsstrahlung des Plasmas oberhalb von 500 Nanometer ausgewertet werden,
wobei mindestens ein Teil der erfassten Emissionsstrahlung des Plasmas von mindestens einem Lichtwellenleiter übertragen wird und mindestens ein Teil des bei der optischen Überwachung ermittelten Signalverlaufes über mindestens einen vorgebbaren Zeitraum integriert wird, wobei mindestens zwei unterschiedliche Spektrallinien ausgewertet werden und wobei alle Intensitäten zu einem vorgebbaren Spektralbereich aufintegriert werden, wobei der vorgebbare Spektralbereich von 700 bis 1000 Nanometer reicht.

Das erfindungsgemäße Verfahren sowie die Vorrichtung sind insbesondere dafür geeignet, den Ablauf eines Beschichtungsverfahrens für Flaschen aus Kunststoff zu überwachen. Es erfolgt hierbei insbesondere eine Innenbeschichtung dieser Flaschen mit einer Schicht aus SiOx, wobei die Haftung der Schicht aus SiOx auf dem Kunststoff durch eine Zwischenschicht verbessert werden kann, die als ein Haftvermittler ausgebildet ist. Das Beschichtungsverfahren wird vorzugsweise als ein PICVD-Plasmaprozess durchgeführt (Plasma impuls chemical vapour deposition). Bei einem derartigen Verfahren wird das Plasma unter Verwendung von Pulsen einer Mikrowelle gezündet. Die Pulse können hinsichtlich ihrer Pulsbreite, des Pulsabstandes sowie der Pulshöhe gesteuert werden.

Unter Verwendung der optischen Überwachung ist es möglich, die Gaszusammensetzung des Plasmas sowie die in das Plasma eingetragene Mikrowellenleistung zu überwachen.

Dieser Eintrag an Mikrowellenleistung steht in direkter Abhängigkeit zur Abstimmung des Mikrowellensystems sowie von der eingetragenen Energie in das Magnetron. Daher ist eine Überwachung der eingetragenen Energie in das Magnetron notwendig, um das Gesamtsystem beurteilen zu können.

Die gemäß dem Stand der Technik bekannte optische Überwachung eines Beschichtungsprozesses im Bereich des sichtbaren Lichtes besitzt den Vorteil, dass sich die beschichteten Werkstücke farblich unterscheiden können und daß hierdurch die Transmissionseigenschaften bezüglich des sichtbaren Lichtes nicht signifikant beeinflusst werden. Erfindungsgemäß erfolgt deshalb eine optische Emissionsspektroskopie oberhalb von 500 Nanometer.

Eine besonders gute Aussagesicherheit läßt sich dadurch erreichen, daß erfindungsgemäß mindestens zwei unterschiedliche Wellenlängen ausgewertet werden.

Zu einem einfachen Vorrichtungsaufbau trägt es bei, daß erfindungsgemäß mindestens ein Teil der erfaßten Emissionsstrahlung des Plasmas von mindestens einem Lichtwellenleiter übertragen wird.

Ebenfalls erweist es sich für die Prozeßüberwachung als vorteilhaft, daß der Lichtwellenleiter mit mindestens einem Fotoelement gekoppelt ist, dessen Signal in einer örtlichen Nähe zum Fotoelement verstärkt wird.

Eine besonders große Sensitivität gegenüber von Störungen ergibt sich dadurch, daß erfindungsgemäß mindestens ein Teil eines bei der optischen Überwachung ermittelten Signalverlaufes über mindestens einen vorgebbaren Zeitraum integriert wird.

In den Zeichnungen sind Ausführungsbeispiele der Erfindung schematisch dargestellt. Es zeigen:
- Fig. 1: Eine Prinzipskizze einer Mehrzahl von Plasmakammern, die auf einem rotierenden Plasmarad angeordnet sind und bei der das Plasmarad mit Eingabe-und Ausgaberädern gekoppelt ist,
- Fig. 2: eine Anordnung ähnlich zu Fig. 1, bei der die Plasmastationen jeweils mit zwei Plasmakammern ausgestattet sind,
- Fig. 3: eine perspektivische Darstellung eines Plasmarades mit einer Vielzahl von Plasmakammern,
- Fig. 4: eine perspektivische Darstellung einer Plasmastation mit einer Kavität,
- Fig. 5: eine Vorderansicht der Vorrichtung gemäß Fig. 4 mit geschlossener Plasmakammer,
- Fig. 6: einen Querschnitt gemäß Schnittlinie VI-VI in Fig. 5,
- Fig. 7: eine optische Verbindung einer dem zu überwachenden Prozeß zugewandten Quarzglasscheibe mit einem Fotoelement unter Verwendung eines Kabels zur Lichtwellenleitung,
- Fig. 8: einen vergrößerten Querschnitt durch das Kabel zur Lichtwellenleitung,
- Fig. 9: ein typisches Emissionsspektrum eines Plasmas zur SiOx-Beschichtung von PET-Flaschen bei der Aufbringung einer Haftschicht,
- Fig. 10: ein Emissionsspektrum entsprechend Fig. 9 bei der Aufbringung einer Barriereschicht und
- Fig. 11: eine Darstellung der Übertragungscharakteristik des verwendeten Lichtwellenleiters.

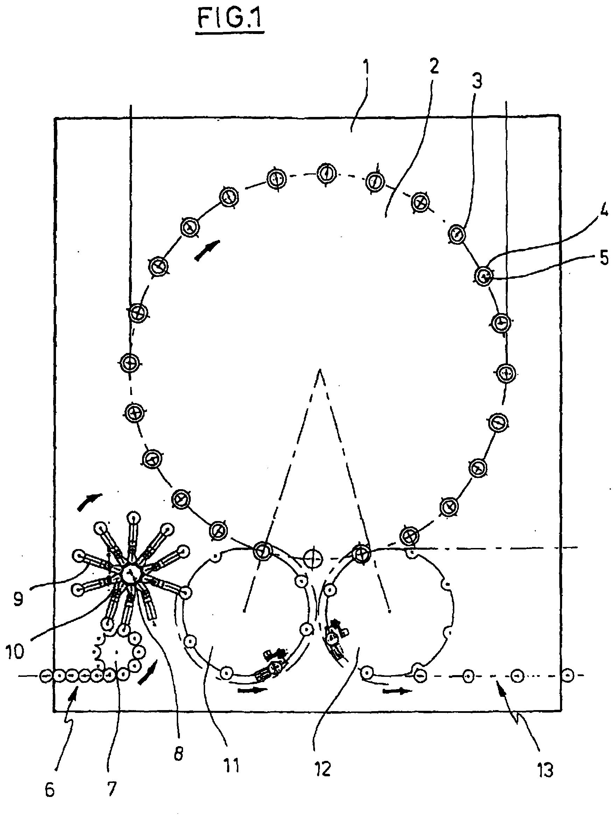

Aus der Darstellung in Fig. 1 ist ein Plasmamodul (1) zu erkennen, das mit einem rotierenden Plasmarad (2) versehen ist. Entlang eines Umfanges des Plasmarades (2) sind eine Mehrzahl von Plasmastationen (3) angeordnet. Die Plasmastationen (3) sind mit Kavitäten (4) bzw. Plasmakammern (17) zur Aufnahme von zu behandelnden Werkstücken (5) versehen.

Die zu behandelnden Werkstücke (5) werden dem Plasmamodul (1) im Bereich einer Eingabe (6) zugeführt und über ein Vereinzelungsrad (7) an ein Übergaberad (8) weitergeleitet, das mit positionierbaren Tragarmen (9) ausgestattet ist. Die Tragarme (9) sind relativ zu einem Sockel (10) des Übergaberades (8) verschwenkbar angeordnet, so daß eine Abstandsveränderung der Werkstücke (5) relativ zueinander durchgeführt werden kann. Hierdurch erfolgt eine Übergabe der Werkstücke (5) vom Übergaberad (8) an ein Eingaberad (11) mit einem relativ zum Vereinzelungsrad (7) vergrößerten Abstand der Werkstücke (5) relativ zueinander. Das Eingaberad (11) übergibt die zu behandelnden Werkstücke (5) an das Plasmarad (2). Nach einer Durchführung der Behandlung werden die behandelten Werkstücke (5) von einem Ausgaberad (12) aus dem Bereich des Plasmarades (2) entfernt und in den Bereich einer Ausgabestrecke (13) überführt.

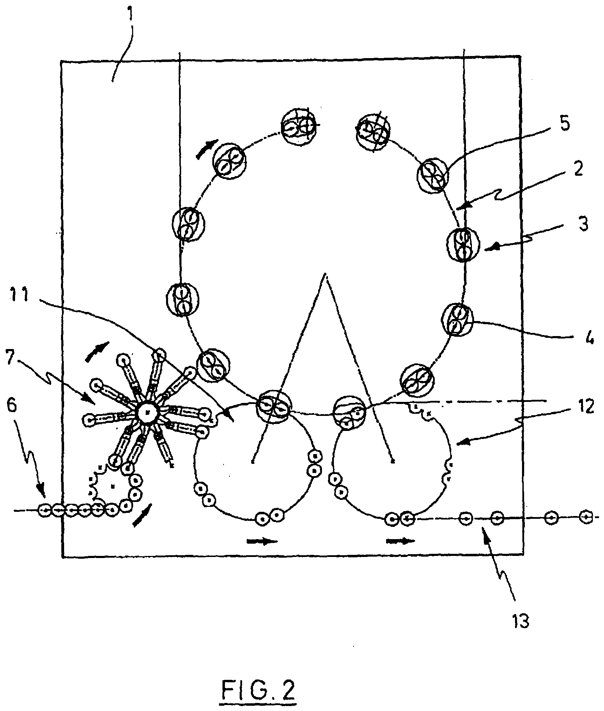

Bei der Ausführungsform gemäß Fig. 2 sind die Plasmastationen (3) jeweils mit zwei Kavitäten (4) bzw. Plasmakammern (17) ausgestattet. Hierdurch können jeweils zwei Werkstücke (5) gleichzeitig behandelt werden. Grundsätzlich ist es hierbei möglich, die Kavitäten (4) vollständig voneinander getrennt auszubilden, grundsätzlich ist es aber auch möglich, in einem gemeinsamen Kavitätenraum lediglich Teilbereiche derart gegeneinander abzugrenzen, daß eine optimale Beschichtung aller Werkstücke (5) gewährleistet ist. Insbesondere ist hierbei daran gedacht, die Teilkavitäten zumindest durch separate Mikrowelleneinkopplungen gegeneinander abzugrenzen.

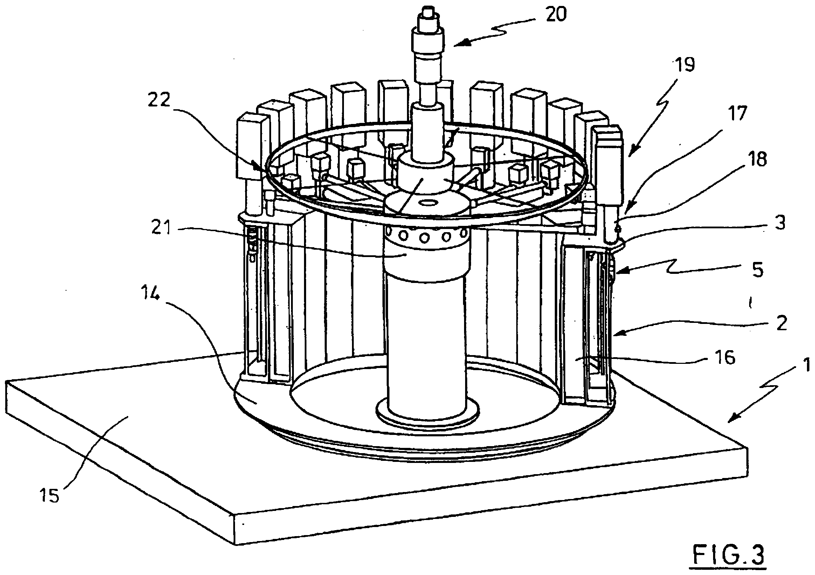

Fig. 3 zeigt eine perspektivische Darstellung eines Plasmamoduls (1) mit teilweise aufgebautem Plasmarad (2). Die Plasmastationen (3) sind auf einem Tragring (14) angeordnet, der als Teil einer Drehverbindung ausgebildet und im Bereich eines Maschinensockels (15) gelagert ist. Die Plasmastationen (3) weisen jeweils einen Stationsrahmen (16) auf, der Plasmakammern (17) haltert. Die Plasmakammern (17) weisen zylinderförmige Kammerwandungen (18) sowie Mikrowellengeneratoren (19) auf.

In einem Zentrum des Plasmarades (2) ist ein Drehverteiler (20) angeordnet, über den die Plasmastationen (3) mit Betriebsmitteln sowie Energie versorgt werden. Zur Betriebsmittelverteilung können insbesondere Ringleitungen (21) eingesetzt werden.

Die zu behandelnden Werkstücke (5) sind unterhalb der zylinderförmigen Kammerwandungen (18) dargestellt. Unterteile der Plasmakammern (17) sind zur Vereinfachung jeweils nicht eingezeichnet.

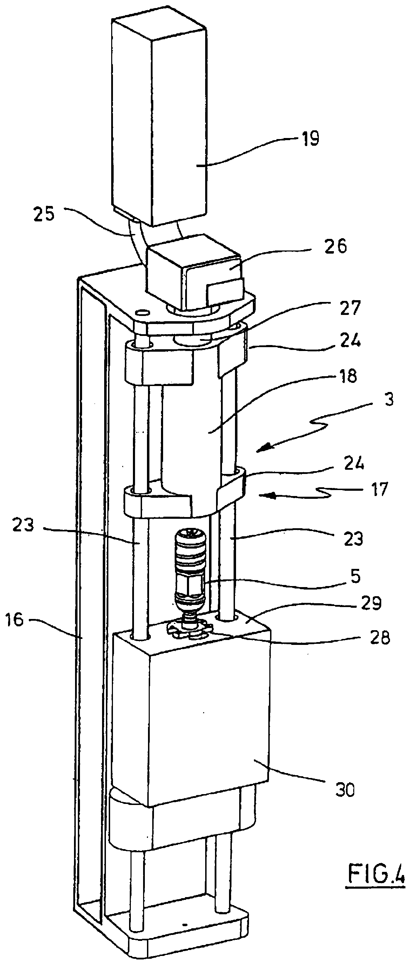

Fig. 4 zeigt eine Plasmastation (3) in perspektivischer Darstellung. Es ist zu erkennen, daß der Stationsrahmen (16) mit Führungsstangen (23) versehen ist, auf denen ein Schlitten (24) zur Halterung der zylinderförmigen Kammerwandung (18) geführt ist. Fig. 4 zeigt den Schlitten (24) mit Kammerwandung (18) in einem angehobenen Zustand, so daß das Werkstück (5) freigegeben ist.

Im oberen Bereich der Plasmastation (3) ist der Mikrowellengenerator (19) angeordnet. Der Mikrowellengenerator (19) ist über eine Umlenkung (25) und einen Adapter (26) an einen Kopplungskanal (27) angeschlossen, der in die Plasmakammer (17) einmündet. Grundsätzlich kann der Mikrowellengenerator (19) sowohl unmittelbar im Bereich des Kammerdeckels (31) als auch über ein Distanzelement an den Kammerdeckel (31) angekoppelt mit einer vorgebbaren Entfernung zum Kammerdeckel (31) und somit in einem größeren Umgebungsbereich des Kammerdeckels (31) angeordnet werden. Der Adapter (26) hat die Funktion eines Übergangselementes und der Kopplungskanal (27) ist als ein Koaxialleiter ausgebildet. Im Bereich einer Einmündung des Kopplungskanals (27) in den Kammerdeckel (31) ist ein Quarzglasfenster angeordnet. Die Umlenkung (25) ist als ein Hohlleiter ausgebildet.

Das Werkstück (5) wird von einem Halteelement (28) positioniert, das im Bereich eines Kammerbodens (29) angeordnet ist. Der Kammerboden (29) ist als Teil eines Kammersockels (30) ausgebildet. Zur Erleichterung einer Justage ist es möglich, den Kammersockel (30) im Bereich der Führungsstangen (23) zu fixieren. Eine andere Variante besteht darin, den Kammersockel (30) direkt am Stationsrahmen (16) zu befestigen. Bei einer derartigen Anordnung ist es beispielsweise auch möglich, die Führungsstangen (23) in vertikaler Richtung zweiteilig auszuführen.

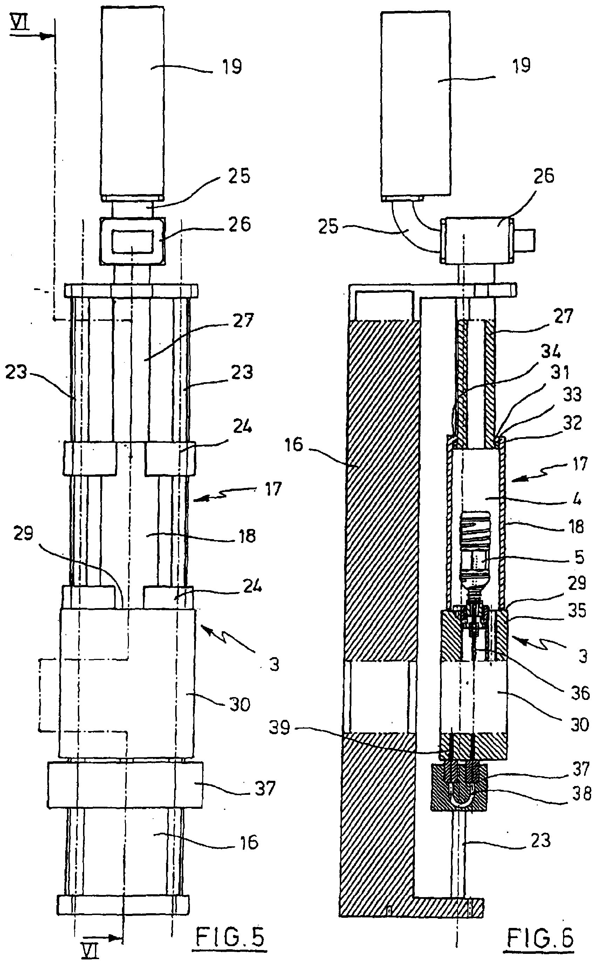

Fig. 5 zeigt eine Vorderansicht der Plasmastation (3) gemäß Fig. 3 in einem geschlossenen Zustand der Plasmakammer (17). Der Schlitten (24) mit der zylinderförmigen Kammerwandung (18) ist hierbei gegenüber der Positionierung in Fig. 4 abgesenkt, so daß die Kammerwandung (18) gegen den Kammerboden (29) gefahren ist. In diesem Positionierzustand kann die Plasmabeschichtung durchgeführt werden.

Fig. 6 zeigt in einer Vertikalschnittdarstellung die Anordnung gemäß Fig. 5. Es ist insbesondere zu erkennen, daß der Kopplungskanal (27) in einen Kammerdeckel (31) einmündet, der einen seitlich überstehenden Flansch (32) aufweist. Im Bereich des Flansches (32) ist eine Dichtung (33) angeordnet, die von einem Innenflansch (34) der Kammerwandung (18) beaufschlagt wird. In einem abgesenkten Zustand der Kammerwandung (18) erfolgt hierdurch eine Abdichtung der Kammerwandung (18) relativ zum Kammerdeckel (31). Eine weitere Dichtung (35) ist in einem unteren Bereich der Kammerwandung (18) angeordnet, um auch hier eine Abdichtung relativ zum Kammerboden (29) zu gewährleisten.

In der in Fig. 6 dargestellten Positionierung umschließt die Kammerwandung (18) die Kavität (4), so daß sowohl ein Innenraum der Kavität (4) als auch ein Innenraum des Werkstückes (5) evakuiert werden können. Zur Unterstützung einer Zuleitung von Prozeßgas ist im Bereich des Kammersockels (30) eine hohle Gaslanze (36) angeordnet, die in den Innenraum des Werkstückes (5) hineinverfahrbar ist. Zur Durchführung einer Positionierung der Gaslanze (36) wird diese von einem Lanzenschlitten (37) gehaltert, der entlang der Führungsstangen (23) positionierbar ist. Innerhalb des Lanzenschlittens (37) verläuft ein Prozeßgaskanal (38), der in der in Fig. 6 dargestellten angehobenen Positionierung mit einem Gasanschluß (39) des Kammersockels (30) gekoppelt ist. Durch diese Anordnung werden schlauchartige Verbindungselemente am Lanzenschlitten (37) vermieden.

Alternativ zur vorstehend erläuterten Konstruktion der Plasmastation ist es erfindungsgemäß aber auch möglich, das Werkstück (5) in eine relativ zur zugeordneten Tragstruktur unbewegliche Plasmakammer (17) einzuführen. Ebenfalls ist es möglich, alternativ zur dargestellten Beschichtung der Werkstücke (5) mit ihren Mündungen in lotrechter Richtung nach unten eine Beschichtung der Werkstücke mit ihren Mündungen in lotrechter Richtung nach oben durchzuführen. Insbesondere ist daran gedacht, eine Beschichtung von flaschenförmigen Werkstücken (5) durchzuführen. Derartige Flaschen sind ebenfalls bevorzugt aus einem thermoplastischen Kunststoff ausgebildet. Vorzugsweise ist an die Verwendung von PET oder PP gedacht. Gemäß einer weiteren bevorzugten Ausführungsform dienen die beschichteten Flaschen zur Aufnahme von Getränken.

Ein typischer Behandlungsvorgang wird im folgenden am Beispiel eines Beschichtungsvorganges erläutert und derart durchgeführt, daß zunächst das Werkstück (5) unter Verwendung des Eingaberades (11) zum Plasmarad (2) transportiert wird und daß in einem hochgeschobenen Zustand der hülsenartigen Kammerwandung (18) das Einsetzen des Werkstückes (5) in die Plasmastation (3) erfolgt.

Nach einem Abschluss des Einsetzvorganges wird die Kammerwandung (18) in ihre abgedichtete Positionierung abgesenkt und zeitlich versetzt folgt eine Verschiebung des Halteelementes (28), sodass eine Abschottung des Innenraumes des Werkstückes (5) gegenüber dem Innenraum der Kavität (4) entsteht. Anschließend wird die Gaslanze (36) in den Innenraum des Werkstückes (5) eingefahren. Ebenfalls ist es möglich, die Gaslanze (36) bereits synchron zur beginnenden Absenkung der Kavität (4) in den Innenraum des Werkstücks (5) hinein zu verfahren. Es folgt eine gleichzeitige oder zeitlich versetzte Evakuierung der Kavität (4) sowie vom Innenraum des Werkstückes (5). Nach einer ausreichenden Evakuierung des Innenraumes der Kavität (4) wird der Druck im Innenraum des Werkstückes (5) anschließend noch weiter abgesenkt. Darüber hinaus ist auch daran gedacht, die Positionierbewegung der Gaslanze (36) wenigstens teilweise bereits parallel zur Positionierung der Kammerwandung (18) durchzuführen.

Nach Erreichen eines ausreichend tiefen Unterdruckes wird Prozeßgas in den Innenraum des Werkstückes (5) eingeleitet und mit Hilfe des Mikrowellengenerators (19) das Plasma gezündet. Insbesondere ist daran gedacht, mit Hilfe des Plasmas sowohl einen Haftvermittler auf eine innere Oberfläche des Werkstückes (5) als auch die eigentliche Barriereschicht aus Siliziumoxiden abzuscheiden.

Nach Abschluss des Beschichtungsvorganges wird die Plasmakammer (17) sowie der Innenraum des Werkstückes (5) belüftet. Nach Erreichen des Umgebungsdruckes innerhalb der Kavität (4) und im Innenraum des Werkstückes (5) wird die Kammerwandung (18) wieder angehoben und die Gaslanze (36) wieder aus dem Innenraum des Werkstückes (5) entfernt. Eine Entnahme des beschichteten Werkstückes (5) sowie eine Eingabe eines neuen zu beschichtenden Werkstückes (5) kann nun durchgeführt werden.

Eine Positionierung der Kammerwandung (18), des Dichtelementes (28) und / oder der Gaslanze (36) kann unter Verwendung unterschiedlicher Antriebsaggregate erfolgen. Grundsätzlich ist die Verwendung pneumatischer Antriebe und / oder elektrischer Antriebe, insbesondere in einer Ausführungsform als Linearmotor, denkbar. Insbesondere ist aber daran gedacht, zur Unterstützung einer exakten Bewegungskoordinierung mit einer Rotation des Plasmarades (2) eine Kurvensteuerung zu realisieren. Die Kurvensteuerung kann beispielsweise derart ausgeführt sein, daß entlang eines Umfanges des Plasmarades (2) Steuerkurven angeordnet sind, entlang derer Kurvenrollen geführt werden. Die Kurvenrollen sind mit den jeweils zu positionierenden Bauelementen gekoppelt.

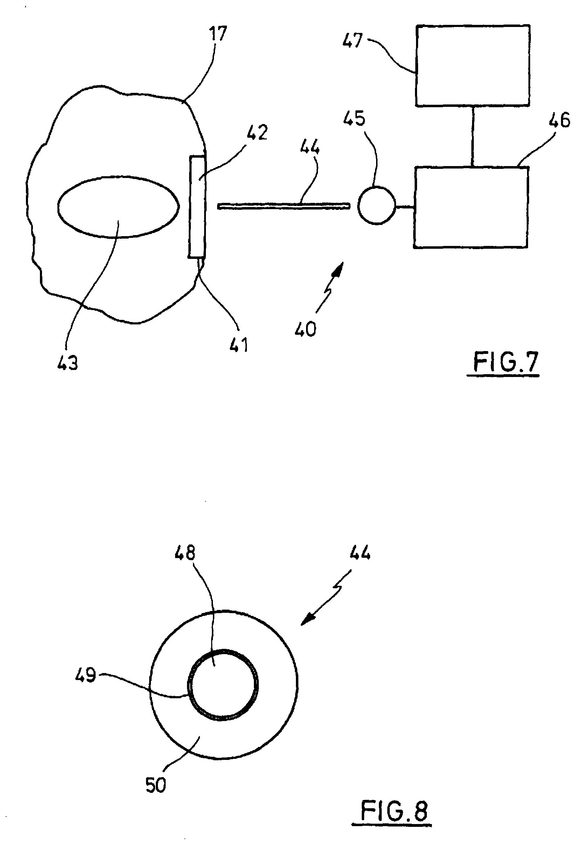

Fig. 7 zeigt eine schematische Darstellung einer Einrichtung (40) zur optischen Überwachung eines Beschichtungsprozesses. Schematisch ist die Plasmakammer (17) dargestellt, die mit einem Fenster (41) versehen ist. In das Fenster (41) ist eine Quarzglasscheibe (42) eingesetzt. Innerhalb der Plasmakammer (17) ist schematisch ein Plasma (43) abgebildet.

Ausgehend von der Quarzglasscheibe (42) erstreckt sich ein Lichtwellenleiter (44) bis zu einem Fotoelement (45). Das Fotoelement (45) ist direkt mit einer Verstärkungsstufe (52) verbunden die typischerweise direkt auf einen Analog-Digital-Wandler (46) gekoppelt wird. Der Analog-DigitalWandler (46) ist an eine Auswertungseinrichtung (47) angeschlossen.

Die Bauelemente (45, 52 46, 47) sind somit beabstandet zur Plasmakammer (17) angeordnet und befinden sich außerhalb einer unmittelbaren Einwirkung des Mikrowellensystems. Das Fotoelement (45) ist direkt mit einer Verstärkungsstufe gekoppelt, um ein kleines Verhältnis von Signalanteilen zu Rauschanteilen zu erreichen. Typische Verstärkungsfaktoren liegen in einem Bereich von 10⁵ bis 10⁹. Im Bereich des Verstärkers wird bevorzugt ein Dunkelstromabgleich realisiert, der eine Kompensation des thermischen Verhaltens der Fotodiode sowie der Verstärkungsstufe ermöglicht. Darüber hinaus wird eine Verstärkungsumschaltung implementiert. Hierdurch ist es möglich, für unterschiedliche Lichtintensitäten eine jeweils optimale Verstärkung bereitzustellen. Das Ausgangssignal des Verstärkers wird dann dem Analog-Digital-Wandler (46) zugeführt. Die direkte Kopplung des Fotoelementes (45) und des Verstärkers kann beispielsweise durch die Anordnung in einer gemeinsamen elektronischen Baugruppe, auf einer gemeinsamen Platine oder auf einem gemeinsamen Halbleiterchip realisiert werden.

Im Bereich der Auswertungseinrichtung (47) ist bevorzugt daran gedacht, das Signal des Analog-Digital-Wandlers (46) über einen vorgegebenen Zeitraum zu integrieren. Die jeweiligen Abtastwerte können zwischengespeichert werden, um eine zeitliche Darstellung der Signalverläufe zu unterstützen.

Fig. 8 zeigt eine vergrößerte Querschnittdarstellung des Lichtwellenleiters (44). Der Lichtwellenleiter besitzt einen optischen Kern (48), einen optischen Mantel (49) sowie eine Außenhülle (50). Der Kern (48) weist typischerweise einen Durchmesser von etwa 400 - 600 Mikrometer auf. Als Material für den optischen Mantel (4) kann PMMA verwendet werden. Für die Außenhülle (50) hat sich die Verwendung von ETFE bewährt.

Eine typische Dämpfung des Lichtwellenleiters (44) bei einer zu übertragenden Wellenlänge von 850 Nanometer beträgt höchstens 8 db/km. Der Faktor NA (Numerische Apertur) beträgt etwa 0,37. Als Material für den optischen Kern (48) wird Quarzglas verwendet.

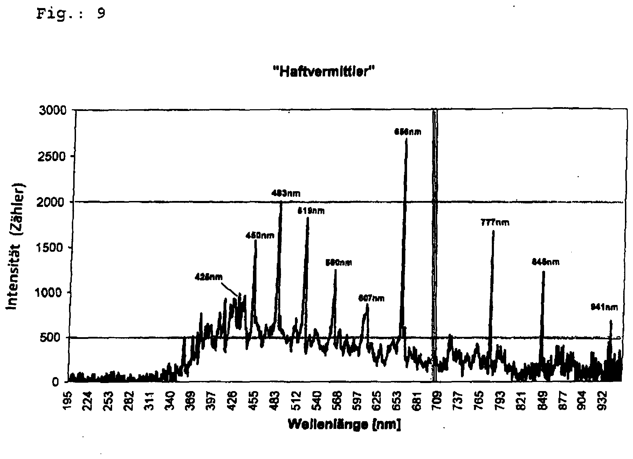

Fig. 9 zeigt einen typischen Transmissionsverlauf bei der Durchführung einer Innenbeschichtung von PET-Flaschen. Es wird hierbei der Prozeßschritt des Aufbringens einer Haftschicht zwischen dem PET-Material und der Schicht aus SiOx durchgeführt. In einem Bereich oberhalb von 700 Nanometer ergeben sich drei charakteristische Spektrallinien. Diese liegen bei 777 Nanometer, 845 Nanometer und 927 Nanometer. Die Überwachung von mindestens zwei dieser Spektrallinien, vorzugsweise von allen drei Spektrallinien, erweist sich als besonders vorteilhaft für die Prozeßüberwachung und gegebenenfalls die Prozeßsteuereung.

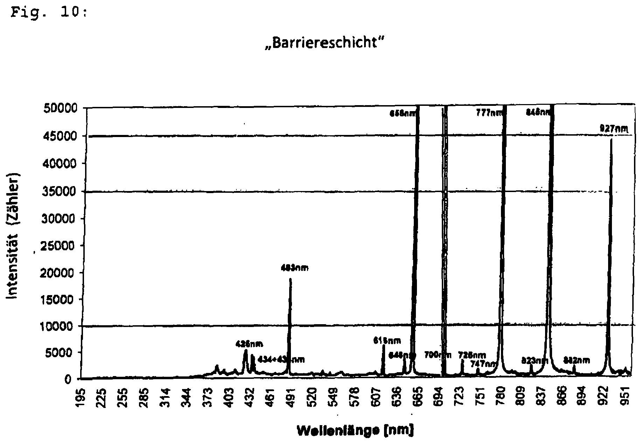

Fig. 10 zeigt einen vergleichbaren Verlauf der Spektrallinien bei der Aufbringung der SiOx-Schicht. Auch hier treten die drei charakteristischen oben genannten Spektrallinien in signifikanter Art und Weise auf.

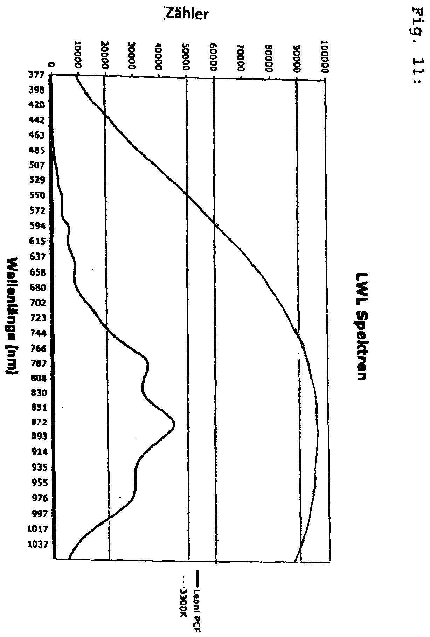

Fig. 11 veranschaulicht typische Spektralbereiche für den bevorzugten Lichtwellenleiter. Der vorstehend näher erläuterte Lichtwellenleiter entspricht dem Verlauf (51).

In den Fig. 9 bis 11 sind jeweils die Intensitäten in Counts dargestellt über der Wellenlänge in Nanometer.

Der Lichtwellenleiter gemäß Fig. 7 besitzt zwei wesentliche Funktionen. Gemäß einer ersten Funktion nimmt der Lichtwellenleiter (44) über seine numerische Apertur das vom Plasma (43) generierte Streulicht auf. Eine spezielle Sammellinse ist hierdurch nicht erforderlich. Die zweite Funktion des Lichtwellenleiters liegt in seiner Eigenschaft als Spektralfilter. Aufgrund des in Fig. 11 veranschaulichten Spektralverhaltens werden unterschiedliche Wellenlängen (Spektrallinien) unterschiedlich gedämpft vom Lichtwellenleiter (44) übertragen. Der Lichtwellenleiter mit dem Verlauf (51) in Fig. 11 weist eine für die Übertragung der Spektrallinien gemäß Fig. 9 und Fig. 10 optimierte Eigenschaft auf.

Als Fotoelement (45) kann eine preiswerte Fotodiode mit einer spektralen Empfindlichkeit in einem Bereich von 700 Nanometer bis 1000 Nanometer verwendet werden. Grundsätzlich wäre auch eine Verwendung von Fotowiderständen oder Fototransistoren als Fotoelemente (45) möglich, Fotodioden weisen jedoch eine sehr geringe Trägheit auf.

Wie bereits erwähnt, wird im Bereich der Auswertungseinrichtung (47) eine Aufintegration der ermittelten Signalverläufe durchgeführt. Die hierdurch ermittelten Flächeninhalte beschreiben die im Signal enthaltene Energie. Die Integration kombiniert eine hohe Sensitivität mit einer hohen Genauigkeit.

Als wesentliche Komponenten für die erfindungsgemäße Prozeßüberwachung sind somit die Signalübertragung über den Lichtwellenleiter (44), die selektive Übertragung von Wellenlängen oberhalb von 700 Nanometer durch die optischen Eigenschaften des Lichtwellenleiters (44), die ortsnah zum Fotoelement (45) durchgeführte Signalverstärkung, die umschaltbare Signalverstärkung und die Integration der Signalverläufe im Bereich der Auswertungseinrichtung (47) anzusehen. Besonders vorteilhaft ist die Realisierung aller fünf vorstehend genannten Eigenschaften in Kombination miteinander, jede einzelne dieser Eigenschaften kann aber auch allein oder in Kombination mit nur einer oder mit zweien oder drei der weiteren Eigenschaften realisiert werden.

Hinsichtlich der Integration ist insbesondere daran gedacht, nicht nur das Signal zu einer einzelnen Spektrallinie, sondern alle Intensitäten zu einem vorgebbaren Spektralbereich aufzuintegrieren. Erfindungsgemäß von 700 Nanometer bis 1000 Nanometer. Die sich ergebene Fläche wird mit einer Referenzfläche verglichen und bei Abweichungen sind Ober- und Untergrenzen einzuhalten.

Für die Prozeßüberwachung erweist sich insbesondere die Sauerstofflinie im Spektralbereich als wesentlich.

## Patentansprüche

1. Verfahren zur Plasmabehandlung von Werkstücken, bei dem das Werkstück in eine Plasmakammer eingesetzt wird und bei dem anschliessend bei Einwirkung eines Unterdruckes nach der Zündung eines Plasmas eine Beschichtung auf dem Werkstück abgeschieden wird sowie bei dem der Verfahrensablauf mindestens zeitweilig optisch überwacht wird, **dadurch gekennzeichnet, dass** bei der optischen Überwachung Wellenlängen der Strahlung des Plasmas oberhalb von 500 Nanometer ausgewertet werden, wobei mindestens ein Teil der erfassten Emissionsstrahlung des Plasmas von mindestens einem Lichtwellenleiter übertragen wird und mindestens ein Teil des bei der optischen Überwachung ermittelten Signalverlaufes über mindestens einen vorgebbaren Zeitraum integriert wird, wobei mindestens zwei unterschiedliche Spektrallinien ausgewertet werden und wobei alle Intensitäten eines vorgebbaren Spektralbereichs aufintegriert werden, wobei der vorgebbare Spektralbereich von 700 bis 1000 Nanometer reicht.

2. Verfahren nach Anspruch 1, **dadurch gekennzeichnet, dass** der Lichtwellenleiter (44) mit mindestens einem Fotoelement (45) gekoppelt ist, dessen Signal in einer örtlichen Nähe zum Fotoelement (45) verstärkt wird.

3. Verfahren nach einem der Ansprüche 1 oder 2, **dadurch gekennzeichnet, dass** die Zündung des Plasmas mithilfe eines Mikrowellengenerators erfolgt, wobei der vom Mikrowellengenerator ausgegebene modulierte Strom-Spannungssignalverlauf, der dem Energieeintrag ins Magnetron entspricht, über mindestens einen vorgebbaren Zeitraum integriert wird.

4. Verfahren nach Anspruch 3, **dadurch gekennzeichnet, dass** der Integrationswert als Referenz verwendet wird in Korrelation zum Integrationswert der optischen Überwachung.

## Claims

1. A method for plasma-treating workpieces, in which the workpiece is inserted into a plasma chamber and in which a coating is subsequently precipitated onto the workpiece after ignition of a plasma under the influence of a negative pressure and in which the process sequence is at least temporarily optically monitored, **characterised in that** wavelengths of the radiation of the plasma above 500 nanometres are evaluated in response to the optical monitoring, wherein at least a portion of the detected emission radiation of the plasma is transferred by at least one optical waveguide and at least a portion of the signal pattern determined in response to the optical monitoring is integrated for at least a predeterminable period of time, wherein at least two different spectral lines are evaluated, and wherein all intensities of a predeterminable spectral range are integrated, wherein the predeterminable spectral range of between 700 and 1000 nanometres is sufficient.

2. The method according to claim 1, **characterised in that** the optical waveguide (44) is coupled to at least one photo element (45), the signal of which is amplified in a local vicinity to the photo element (45).

3. The method according to any one of claims 1 or 2, **characterised in that** the ignition of the plasma occurs with the help of a microwave generator, wherein the modulated current-voltage signal pattern, which is output by the microwave generator and which corresponds to the energy input into the magnetron, is integrated for at least a predeterminable period of time.

4. The method according to claim 3, **characterised in that** the integration value is used as reference in correlation with the integration value of the optical monitoring.

## Revendications

1. Procédé de traitement au plasma de pièces dans le cadre duquel la pièce est introduite dans une chambre à plasma, après quoi, sous l'effet d'une dépression après l'amorçage d'un plasma, un revêtement est déposé sur la pièce, le déroulement du procédé étant temporairement au moins contrôlé optiquement, **caractérisé en ce que**, lors du contrôle optique, des longueurs d'onde du rayonnement du plasma supérieures à 500 nanomètres sont évaluées, une partie au moins du rayonnement détecté émis par le plasma étant transmise par au moins un guide d'ondes optiques et une partie au moins de la variation de signal déterminée étant intégrée sur au moins un intervalle de temps prédéfinissable, deux raies spectrales différentes au moins étant évaluées et toutes les intensités d'une partie prédéfinissable du spectre étant intégrées, la partie prédéfinissable du spectre allant de 700 à 1000 nanomètres.

2. Procédé selon la revendication 1, **caractérisé en ce que** le guide d'ondes optiques (44) est couplé avec au moins une cellule photoélectrique (45) dont le signal est amplifié à proximité de la cellule photoélectrique (45).

3. Procédé selon l'une des revendications 1 ou 2, **caractérisé en ce que** l'amorçage du plasma a lieu à l'aide d'un générateur de micro-ondes, la variation du signal de courant-tension modulé émis par le générateur de micro-ondes et correspondant à l'apport d'énergie dans le magnétron étant intégrée sur au moins un intervalle de temps prédéfinissable.

4. Procédé selon la revendication 3, **caractérisé en ce que** la valeur d'intégration est utilisée comme référence en corrélation avec la valeur d'intégration du contrôle optique.
